# EUROPÄISCHE PATENTANMELDUNG

(11) **EP 2 790 217 A1**
(43) Veröffentlichungstag der Anmeldung: **15.10.2014**
(21) Anmeldenummer: 13162942.0
(22) Anmeldetag: 09.04.2013
(51) Int. Cl.: H01L 25/07, H01L 23/051

(54) **Leistungshalbleitermodul**

(71) Anmelder: ABB Technology AG, 8050 Zürich (CH)
(72) Erfinder: Hartmann, Samuel, 5603 Staufen (CH); Dugal, Franc, 8702 Zollikon (CH); Ekwall, Olle, 77143 Ludvika (SE); Doré, Erik, 77134 Ludvika (SE)
(74) Vertreter: ABB Patent Attorneys

(57) **Zusammenfassung**

Ein erfindungsgemässe Leistungshalbleitermodul (10) weist eine erste Hauptelektrode (12), eine zweite Hauptelektrode (14) und einen Kontrollanschluss (16) auf. Weiter weist das Leistungshalbleitermodul (10) steuerbare Leistungshalbleiterbauelemente (18) auf, welche zwischen der ersten Hauptelektrode (12) und der zweiten Hauptelektrode (14) angeordnet sind. Erfindungsgemäss ist das Leistungshalbleitermodul (10) dadurch gekennzeichnet, dass zumindest ein Teil der steuerbaren Leistungshalbleiterbauelemente (18) in einer Ringanordnung (28, 28, 28") angeordnet sind, wobei die steuerbaren Leistungshalbleiterbauelemente (18) der Ringanordnung (28, 28', 28") zumindest annähernd entlang einer ersten Kreislinie (30) der Ringanordnung (28, 28', 28") angeordnet sind und eine Kontrollleiterbahn (32) der Ringanordnung (28, 28', 28") auf der ersten Hauptelektrode (12) angeordnet ist, wobei die Kontrolleiterbahn (32) zumindest annähernd entlang einer zweiten Kreislinie (34) der Ringanordnung (28, 28', 28") verläuft, und die zweite Kreislinie (34) konzentrisch zur ersten Kreislinie (30) verläuft.

## Beschreibung

Die vorliegende Erfindung betrifft ein Leistungshalbleitermodul gemäss dem Oberbegriff von Anspruch 1.

Derartige Leistungshalbleitermodule sind auch dem Stand der Technik bekannt und beispielsweise in EP 0 989 611 A2, US 6426561, EP 1 403 923 A1 oder WO 2012/107482 A2 beschrieben. Diese Module werden beispielsweise für Stromrichteranlagen für die Hochspannungs-Gleichstrom-Übertragung verwendet. Typischerweise wird ein Leistungshalbleitermodul minimal mit mehr als 500 V und mit mehr als 1 kA im Betrieb belastet. Bei Anwendung der Leistungshalbleitermodule in einer Stromrichteranlage für die Hochspannungs-Gleichstrom-Übertragung werden die Leistungshalbleitermodule in Serie geschaltet um die notwendige Sperrspannung zu erreichen.

Typischerweise werden zwischen 100 und 1000 Leistungshalbleitermodule in Serie geschaltet.

Weiter werden derartige Leistungshalbleitermodule auch für statische Blindleistungskompensatoren verwendet, welche auf Englisch als "static VAR compensator" bezeichnet werden.

Bei den bekannten Leistungshalbleitermodulen erweist es sich als nachteilig, dass aufgrund des magnetischen Feldes, welche ein durch die Leistungshalbleitermodule fliessender Strom erzeugt, die in den Leistungshalbleitermodul angeordneten Leistungshalbleiterbauelemente ungleichmässig belastet werden. Dies kann insbesondere zu einer Überlastung einzelner Leistungshalbleiterbauelemente führen. Eine Überlastung eines Leistungshalbleiterbauelementes hat den Ausfall des Moduls zur Folge, in welchem das überlastete Leistungshalbleiterbauelement angeordnet ist.

Aufgabe der vorliegenden Erfindung ist es, ein Leistungshalbleitermodul anzugeben, in welchem die Leistungshalbleiterbauelemente möglichst gleichmässig belastet sind.

Diese Aufgabe wird erfindungsgemäss durch ein Leistungshalbleitermodul gemäss Anspruch 1 gelöst. In den abhängigen Ansprüchen sind vorteilhafte Weiterbildungen der Erfindung angegeben.

Das erfindungsgemässe Leistungshalbleitermodul weist eine erste Hauptelektrode, eine zweite Hauptelektrode und einen Kontrollanschluss auf. Weiter weist das Leistungshalbleitermodul steuerbare Leistungshalbleiterbauelemente auf, welche zwischen der ersten Hauptelektrode und der zweiten Hauptelektrode angeordnet sind, wobei jedes steuerbare Leistungshalbleiterbauelement eine erste Elektrode, eine zweite Elektrode und eine Kontrollelektrode aufweist und die erste Elektrode jedes steuerbaren Leistungshalbleiterbauelementes mit der ersten Hauptelektrode, die zweite Elektrode jedes steuerbaren Leistungshalbleiterbauelementes mit der zweiten Hauptelektrode und die Kontrollelektrode jedes steuerbaren Leistungshalbleiterbauelementes mit dem Kontrollanschluss elektrisch verbunden ist. Erfindungsgemäss ist das Leistungshalbleitermodul dadurch gekennzeichnet, dass zumindest ein Teil der steuerbaren Leistungshalbleiterbauelemente in einer Ringanordnung angeordnet sind, wobei die steuerbaren Leistungshalbleiterbauelemente der Ringanordnung zumindest annähernd entlang einer ersten Kreislinie der Ringanordnung angeordnet sind und eine Kontrollleiterbahn der Ringanordnung auf der ersten Hauptelektrode angeordnet ist, wobei die Kontrolleiterbahn der Ringanordnung zumindest annähernd entlang einer zweiten Kreislinie der Ringanordnung verläuft, und die zweite Kreislinie der Ringanordnung konzentrisch zur ersten Kreislinie der Ringanordnung verläuft, wobei die Kontrollelektrode jedes steuerbaren Leistungshalbleiterbauelementes der Ringanordnung über eine elektrische Verbindung mit der Kontrollleiterbahn der Ringanordnung verbunden ist und die Kontrolleiterbahn der Ringanordnung über eine weitere elektrische Verbindung mit dem Kontrollanschluss verbunden ist.

Erfindungsgemäss sind die Leistungshalbleiterbauelemente in einer Ringanordnung angeordnet. Durch die Ringanordnung beziehungsweise durch die Anordnung der steuerbaren Leistungshalbleiterbauelemente zumindest annähernd entlang einer Kreislinie, sind die Leistungshalbleiterbauelemente der Ringanordnung im Wesentlichen einem gleichen oder zumindest ähnlichen Magnetfeld während des Betriebes ausgesetzt. Weiter verläuft die Kontrollleiterbahn der Ringanordnung zumindest annähernd entlang einer zweiten Kreislinie, wobei die zweite Kreislinie konzentrisch zur ersten Kreislinie verläuft. Somit koppelt in jede Leiterschleife, welche den Kontrollanschluss, die Kontrollelektrode des jeweiligen Leistungshalbleiterbauelements, die zweite Elektrode des jeweiligen Leistungshalbleiterbauelements und die zweite Hauptelektrode aufweist, ein zumindest annähernd ähnliches Magnetfeld in jede der Leiterschleifen ein, womit das Schaltverhalten der Leistungshalbleiterbauelemente der Ringanordnung durch das Magnetfeld zumindest annähern gleich beeinflusst wird.

Gemäss einer bevorzugten Ausführungsform des Leistungshalbleitermoduls ist die erste Kreislinie durch ein erstes Vieleck und die dazugehörige zweite Kreislinie durch ein zweites Vieleck mit derselben Anzahl Ecken wie das erste Vieleck angenähert, wobei die Ecken des ersten Vieleckes auf die Ecken des zweiten Vieleckes ausgerichtet sind.

Durch diese Ausführungsform ist insbesondere eine wirtschaftliche Produktion der Leistungshalbleitermodule möglich, wobei Abweichungen von der Kreissymmetrie auf das Schaltverhalten gering ausfallen.

Gemäss einer bevorzugten Ausführungsform des Leistungshalbleitermoduls liegt die zweite Kreislinie ausserhalb der ersten Kreislinie liegt.

Im Vergleich zu einer zweiten Kreislinie, die innerhalb der ersten Kreislinie liegen würde, führt diese Ausführungsform wegen der Einkopplung des Magnetfeldes in die oben definierten Leiterschleifen zu einem verzögertem Schaltverhalten jedes Leistungshalbleiterbauelementes. Dies wirkt sich insbesondere günstig auf das Kurzschlussverhalten des Leistungshalbleitermoduls aus.

Gemäss einer bevorzugten Ausführungsform des Leistungshalbleitermoduls weist das Leistungshalbleitermodul aktive Baugruppen auf, wobei jede aktive Baugruppe eine elektrisch leitende Trägerplatte aufweist, und die Trägerplatten der aktiven Baugruppen zusammen die erste Hauptelektrode bilden. Weiter ist jede Ringanordnung durch die aktiven Baugruppen in Ringsegmente aufgeteilt, wobei die aktiven Leistungshalbleiterbauelemente des Ringsegmentes auf der Trägerplatte angeordnet sind, und die Kontrolleiterbahn der jeweiligen Ringanordnung in Kontrolleiterbahnsegmente der Ringanordnung unterteilt ist, wobei die Kontrollelektrode jedes Leistungshalbleiterbauelementes des jeweiligen Ringsegments mit dem Kontrolleiterbahnsegment des jeweiligen Ringsegments verbunden ist.

Durch diese Ausführungsform des Leistungshalbleitermoduls ist eine wirtschaftliche Produktion möglich, da Baugruppen produziert und getestet werden können. Funktionstüchtige Baugruppen können zu einem Leistungshalbleitermodul kombiniert werden.

Gemäss einer bevorzugten Ausführungsform des Leistungshalbleitermoduls weist das Leistungshalbleitermodul mehrere, konzentrisch zueinander angeordnete Ringanordnungen au.

Durch diese Ausführungsform wird eine optimale Ausnutzung des Platzes ermöglicht beziehungsweise es wird eine hohe Leistungsdichte erzielt.

Gemäss einer bevorzugten Ausführungsform des Leistungshalbleitermoduls überlappen sich die Ringanordnungen nicht. Mit anderen Worten, die Ringanordnungen sind überlappungsfrei.

Durch diese Ausführungsform ist eine kostengünstige Produktion möglich.

Gemäss einer bevorzugten Ausführungsform des Leistungshalbleitermoduls sind alle aktiven Leistungshalbleiterbauelemente in der Ringanordnung beziehungsweise den Ringanordnungen angeordnet.

Durch diese Ausführungsform des Leistungshalbleitermoduls kann das Schaltverhalten aller Leistungshalbleiterbauelemente optimiert werden.

Gemäss einer bevorzugten Ausführungsform des Leistungshalbleitermoduls sind die aktiven Baugruppen des Leistungshalbleitermoduls alle gleich ausgebildet.

Durch diese Ausführungsform ist eine wirtschaftliche Produktion möglich.

Gemäss einer bevorzugten Ausführungsform des Leistungshalbleitermoduls ist zwischen der zweiten Hauptelektrode des Leistungshalbleitermoduls und jedem steuerbaren Leistungshalbleiterbauelement ein elektrisch leitendes Kontaktelement angeordnet, welches die zweite Hauptelektrode mit der zweiten Elektrode des Leistungshalbleiterbauelements verbindet, wobei durch das Kontaktelement und das Leistungshalbleierbauelement eine Stromführungsrichtung definiert wird, welche zumindest annähern rechtwinklig zur ersten Hauptelektrode ist.

Durch diese Ausführungsform des Leistungshalbleitermoduls lässt sich ein stapelbares Modul mit einem verhältnismässig einfachen Aufbau realisieren.

Gemäss einer weiteren Ausführungsform des Leistungshalbleitermoduls, welche sich mit sämtlichen andere Ausführungsformen kombinierbar ist, ist die erste Hauptelektrode parallel zur zweiten Hauptelektrode.

Gemäss einer bevorzugen Ausführungsform des Leistungshalbleitermoduls ist jedes Kontaktelement als Presskontakt ausgebildet.

Diese Ausführungsform ermöglicht auf einfachste Weise eine Realisierung eines elektrischen Kontaktes mittels Druck, wobei zum Herstellen des elektrischen Kontaktes auf ein Lot oder andere elektrische Verbindungsschicht verzichtet werden kann. Weiter ermöglicht diese Ausführungsform eine Kompensation der unterschiedlichen Bauhöhen der Leistungshalbleiterbauelemente wie auch der Kontaktelemente. Die unterschiedlichen Bauhöhen sind produktionsbeding. Weiter ermöglicht diese Ausführungsform dank dem Federweg des Presskonaktes ein adaptives Ausrichten der ersten Hauptelektrode gegenüber der zweiten Hauptelektrode..

Gemäss einer bevorzugten Ausführungsform des Leistungshalbleitermoduls verläuft die weitere elektrische Verbindung zumindest im Wesentlichen parallel zur Stromführungsrichtung.

Gemäss einer bevorzugten Ausführungsform des Leistungshalbleitermoduls weist das Leistungshalbleitermodul einen Rahmen aus Isoliermaterial auf, in welchen die aktiven Baugruppen eingesetzt sind.

Dank dieser Ausführungsform kann das Leistungshalbleitermodul wirtschaftlich aus aktiven Baugruppen aufgebaut werden.

Gemäss einer bevorzugen Ausführungsform des Leistungshalbleitermoduls weist das das Leistungshalbleitermodul ein zentrales Durchgangsloch aufweist.

Dank dieser Ausführungsform können Leistungshalbleitermodule, welche gestapelt sind, mittels eines Stabes, welcher durch die Durchgangslöcher geführt wird, gegeneinander verspannt werden, wodurch zwischen anliegenden ersten Hauptelektroden und zweiten Hauptelektroden ein optimaler Kontaktdruck hergestellt ist. Optional können zwischen benachbarter erster Hauptelektrode und zweiter Hauptelektrode zweier Leistungshalbleitermodule ein Kühlkörper angeordnet sein.

Gemäss einer weiteren bevorzugten Ausführungsform des Leistungshalbleitermoduls sind die schaltbaren Leistungshalbleiterbauelemente als rückwärtsleidende IGBTs ausgebildet, welche auch als RC-IGBTs bezeichnet werden. Alternativ können auch herkömmliche IGBTs verwendet werden, wobei in diesem Fall zusätzlich antiparallele Leistungshalbleiterdioden zu den IGBTs anzuordnen sind. Die Dioden können beispielsweise anstelle eines schaltbaren Leistungshalbleiterbauelementes angeordnet sein. In den Ausführungsformen mit aktiven Baugruppen, können die schaltbaren Leistungshalbleiterbauelemente einer der Baugruppen durch Leistungshalbeiterdioden ausgebildet sein, wobei in diesem Fall der Aufbau der Baugruppe vereinfacht werden kann, da die Leistungshalbleiterdioden keine Kontrollelektroden aufweisen. Beispielsweise könnten im Rahmen zwei aktive Baugruppen mit Leistungshalbleiterdioden und vier aktive Baugruppen mit IGBTs bestückt sein. Andere Anordnungen sind auch denkbar und für den Fachmann offensichtlich.

Die vorstehend aufgeführten und weitere Aufgaben, Vorteile und Merkmale der vorliegenden Erfindung werden aus der nachfolgenden detaillierten Beschreibung bevorzugter Ausführungsformen der Erfindung in Verbindung mit der Zeichnung offensichtlich.

Kurze Beschreibung der Zeichnungsfiguren

Es zeigen rein schematisch:
Fig.1 1 in Draufsicht ein geöffnetes Leistungshalbleitermodul gemäss einer ersten Ausführungsform, wobei eine zweite Hauptelektrode sowie ein Kontrollanschluss entfernt sind;
Fig. 2 in Schnittdarstellung entlang der in Fig. 1 eingezeichneten Schnittlinie A-B; wobei die zweite Hauptelektrode und der Kontrollanschluss gezeigt sind;
Fig. 3 in Draufsicht ein geöffnetes Leistungshalbleitermodul gemäss einer zweiten Ausführungsform, wobei die zweite Hauptelektrode sowie der Kontrollanschluss entfernt sind;
Fig. 4 in perspektivischer Darstellung ein geöffnetes Leistungshalbleitermodul gemäss einer weiteren Ausführungsform, wobei die zweite Hauptelektrode entfernt ist;
Fig. 5 in perspektivischer Darstellung das Leistungshalbleitermodul gemäss Fig. 4, wobei die zweite Hauptelektrode ebenfalls gezeigt ist;
Fig. 6 in Draufsicht eine aktive Baugruppe, welche in dem in Fig. 4 und 5 gezeigten Leistungshalbleitermodul verwendet wird; und
Fig. 7 die in Fig. 6 gezeigte aktive Baugruppe in perspektivischer Darstellung, wobei ein Baugruppenrahmen zwecks besserer Sichtbarkeit der einzelnen Elemente der aktiven Baugruppe nicht gezeigt ist.

Die in der Zeichnung verwendeten Bezugszeichen und deren Bedeutung sind in der Bezugszeichenliste zusammengefasst aufgelistet. Grundsätzlich sind in den Figuren gleiche Teile mit gleichen Bezugszeichen versehen und werden daher nur einmal beschrieben.

### Beschreibung der Ausführungsarten

Die nachfolgend beschriebenen Ausführungsformen stehen beispielhaft für den Erfindungsgegenstand und haben keine beschränkende Wirkung.

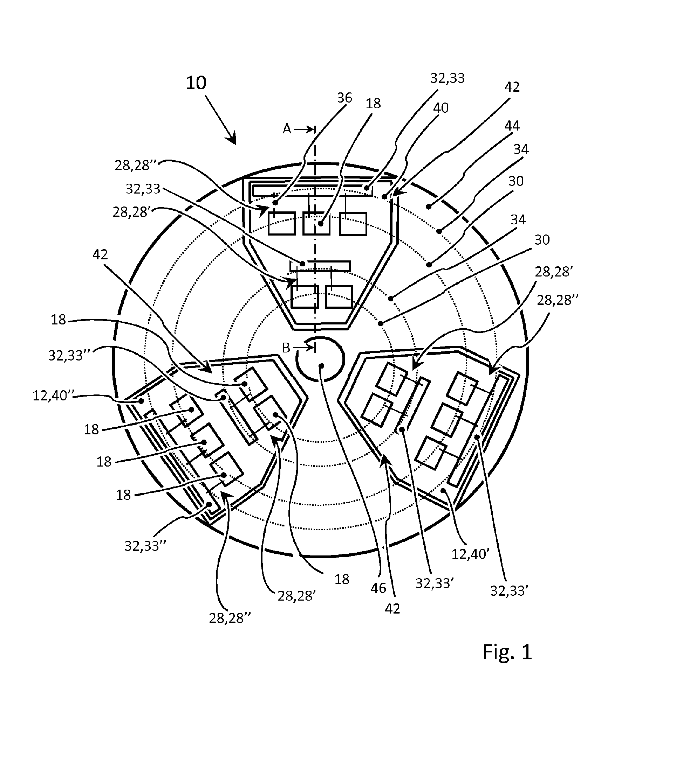

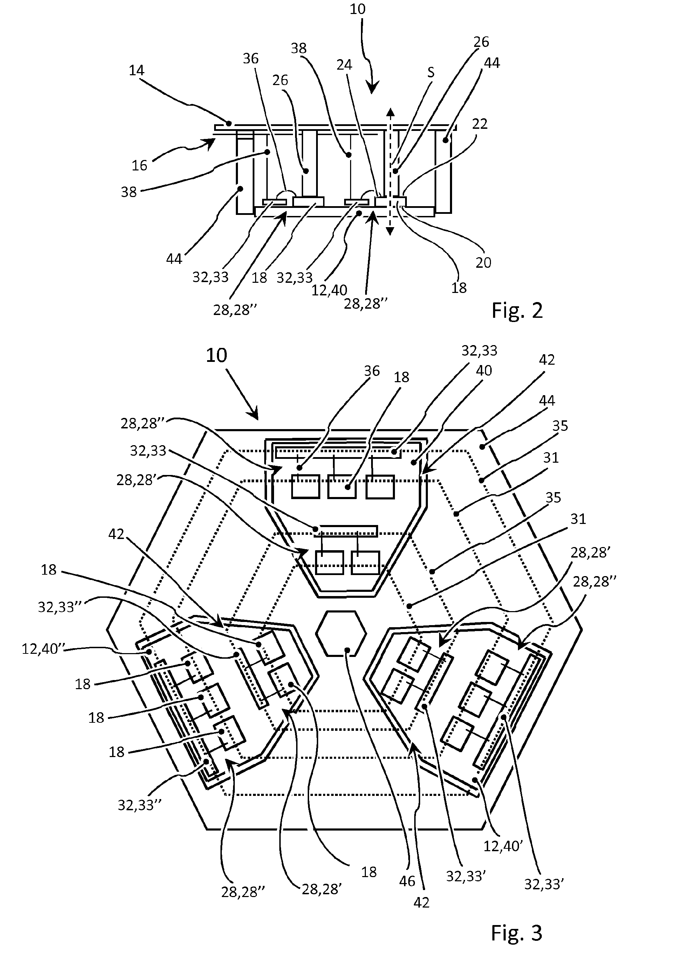

Fig. 1 und Fig. 2 zeigen eine erste Ausführungsform eines Leistungshalbleitermodul 10 mit einer ersten Hauptelektrode 12 und einer zweiten Hauptelektrode 14, welche nur in Fig. 2 gezeigt ist. Das Leistungshalbleitermodul 10 weist weiter einen, in Fig. 2 gezeigten Kontrollanschluss 16 auf, welcher gegenüber der zweiten Hauptelektrode 14 in bekannter Art und Weise isoliert an der zweiten Hauptelektrode 14 angeordnet ist. Wie insbesondere Fig. 2 zeigt, sind zwischen der ersten Hauptelektrode 12 und der zweiten Hauptelektrode 14 steuerbare Leistungshalbleiterbauelemente 18 angeordnet. Jedes steuerbare Leistungshalbleiterbauelement 18 weist eine erste Elektrode 20, eine zweite Elektrode 22 und eine Kontrollelektrode 24 auf. Die erste Elektrode 20 jedes steuerbaren Leistungshalbleiterbauelements 18 ist mittels einer Verbindungsschicht elektrisch mit der ersten Hauptelektrode 12 verbunden. Die Verbindungsschicht kann beispielsweise durch eine Lotschicht oder durch eine durch ein Sinterverfahren hergestellte Verbindungsschicht ausgebildet sein. Die zweite Elektrode 22 ist über ein Kontaktelement 26 mit der zweiten Hauptelektrode 14 elektrisch verbunden.

Wie insbesondere Fig. 1 zeigt, sind die steuerbaren Leistungshalbleiterbauelemente 18 in einer inneren Ringanordnung 28' und einer äusseren Ringanordnung 28" angeordnet, welche konzentrisch zueinander sind. Anstelle dieser zwei Ringanordnungen 28', 28" können die Leistungshalbleiterbauelemente 18 auch in einer einzigen Ringanordnung oder mehreren, zueinander konzentrischen Ringanordnungen angeordnet sein. Ringanordnungen werden allgemein durch das Bezugszeichen 28 bezeichnet. Weiter überlappen sich die einzelnen, konzentrisch zueinander angeordneten Ringanordnungen nicht. Sie sind folglich überlappungsfrei.

In jeder Ringanordnung 28, insbesondere in der in Fig. 1 gezeigten inneren und äusseren Ringanordnung 28', 28" sind die steuerbaren Leistungshalbeiterbauelemente 18 entlang einer ersten Kreislinie 30 der jeweiligen Ringanordnung 28 angeordnet. Weiter weist jede Ringanordnung 28 eine Kontrollleiterbahn 32 auf, welche isoliert von der ersten Hauptelektrode 12 auf dieser angeordnet ist. Die Kontrolleiterbahn 32 der jeweiligen Ringanordnung 28 verläuft entlang einer zweiten Kreislinie 34, wobei die zweite Kreislinie 34 konzentrisch zur ersten Kreislinie 30 liegt. Wie in Fig. 1 gezeigt, ist die Kontrollleiterbahn 32 der jeweiligen Ringanordnung 28 durch mehrere Kontrollleiterbahnsegmente 33, 33', 33" ausgebildet. Jede Kontrollelektrode 24 der steuerbaren Leistungshalbleiterbauelemente 18 der Ringanordnung 28 ist über eine elektrische Verbindung 36, beispielsweise über einen Draht, mit der Kontrollleiterbahn 32 verbunden, wobei die Verbindung 36 bevorzugt im Wesentlichen in radialer Richtung bezüglich der erste Kreislinie 30 beziehungsweise der zweiten Kreislinie 34 verläuft.

Wie Fig. 2 zeigen, ist die Kontrollleiterbahn 32 bzw. jedes Kontrollleiterbahnsegment 33, 33', 33" über eine weitere elektrische Verbindung 38 mit dem Kontrollanschluss 16 verbunden. Alternative ist es auch möglich, die einzelnen Kontrollleiterbahnsegmente 33, 33', 33" entlang der zweiten Kreislinie 34 untereinander zu verbinden und zumindest eines der Kontrolleiterbahnsegmente 33, 33', 33" über die weitere elektrische Verbindung 38 mit dem Kontrollanschluss 16 zu verbinden.

Weiter ist es bevorzugt, dass die weitere elektrische Verbindung 38 parallel zu einer weiter unten definierten Stromführungsrichtung S verläuft. Alternativ, kann die weitere elektrische Verbindung 38 im Wesentlichen auch auf einer konzentrisch zur ersten Kreislinie 30 oder zweiten Kreislinie 34 liegenden Kreiszylindermantelfläche verlaufen. Als weitere Alternative ist auch denkbar, dass das weitere elektrische Verbindungselement gegenüber der aktiven Baugruppe 42 jeweils gleich ausgerichtet ist.

Wie Fig. 1 zeigt, liegt die zweite Kreislinie 34 der jeweiligen Ringanordnung 28 ausserhalb der ersten Kreislinie 30 derselben Ringanordnung 28. Anders ausgedrückt, ist der Radius der zweiten Kreislinie 34 grösser als der Radius der ersten Kreislinie 30.

Wie Fig. 1 weiter zeigt, ist die erste Hauptelektrode 12 dreiteilig ausgebildet. Im allgemeinen kann die erste Hauptelektrode 12 durch eine beliebige Anzahl von Trägerplatten ausgebildet sein, welche zusammen die erste Hauptelektrode 12 bilden. Im vorliegenden Ausführungsbeispiel ist die erste Hauptelektrode 12 durch die drei Trägerplatten 40, 40', 40" ausgebildet. Durch die Trägerplatten 40, 40', 40" werden im Leistungshalbleitermodul 10 aktive Baugruppen 42 ausgebildet. Weiter wird durch die aktiven Baugruppen 42 jede Ringanordnung 28, 28', 28" in Ringsegmente unterteilt. Wie Fig. 1 zeigt, werden durch die aktiven Baugruppen die innere Ringanordnung 28' wie auch die äussere Ringanordnung 28" in je drei Ringsegmente aufgeteilt.

Auf einer ersten Seite jeder Trägerplatte 40, 40', 40" sind folglich die aktiven Leistungshalbleiterblauelemente 18 angeordnet und elektrisch leitend mit dieser verbunden. Die Hauptelektrode 12 wird insbesondere durch jene Seite der Trägerplatte ausgebildet, welche den ersten Seite gegenüberliegend ist.

Wie Fig. 1 wie auch Fig. 2 weiter zeigt, sind die aktiven Baugruppen 42 durch einen Rahmen 44 gehalten beziehungsweise in einen Rahmen 44 eingesetzt. Der Rahmen 44 ist aus einem Isolierstoff gefertigt. Fig. 1 zeigt weiter, dass das Leistungshalbleitermodul 10 mittig ein optionales Durchgangsloch 46 aufweist. Durch dieses kann ein Stab geführt werden, mittels welchem mehrere, aufeinander gestapelte Leistungshalbleitermodul 10 gegeneinander verspannt werden können.

Wie Fig. 1 weiter zeigt, sind alle steuerbaren Leistungshalbleiterbauelemente 18 in den Ringanordnungen 28, 28', 28" angeordnet. Steuerbare Leistungshalbleiterbauelemente 18 können aber auch ausserhalb von Ringanordnungen angeordnet sein. Um die Leistungsfähigkeit des Leistungshalbleitermoduls zu erhöhen könnte in der Mitte des Leistungshalbleitermoduls anstelle des Durchgangslochs ein einziges Leistungshalbleiterbauelement angeordnet sein.

Wie insbesondere Fig. 2 zeigt, ist die zweite Elektrode 22 jedes Leistungshalbleiterbauelement 18 durch das Kontaktelement 26 kontaktiert. Das Kontaktelement 26 stellt die elektrische Verbindung zwischen der zweiten Elektrode 22 des Leistungshalbleiterbauelements 18 und der zweiten Hauptelektrode 14 des Leistungshalbleitermodul 10 her. Weiter ist das Kontaktelement 26 ein wichtiges Element, damit das Leistungshalbleitermodul 10 im Fehlerfall in einen leitenden Zustand übergeht, welcher im Englischen als short circuit failure mode (SCFM) bekannt ist. Dies ist aus dem Stand der Technik bekannt und ist beispielsweise in, EP 0 989 611 A2, US 6426561, EP 1 403 923 A1 oder WO 2012/107482 A2 beschrieben.

Durch das Kontaktelement 26 und durch das vom jeweiligen Kontaktelement 26 kontaktierte Leistungshalbleiterbauelement 18 wird eine Stromführungsrichtung S definiert. Diese ist zumindest annähernd rechtwinklig zur ersten Hauptelektrode 12.

Das Kontaktelement 26 kann, wie beispielsweise in EP 0 989 611 A2, US 6426561 oder EP 1 403 923 A1 beschrieben einen Presskontakt aufweisen. Dieser kann wie aus dem Stand der Technik bekannt durch eine Feder realisiert werden. Weiter kann das Kontaktelement 26 Aluminium, Silber, Gold, Kupfer oder Magnesium aber auch eine Metallschicht aus einem anderen geeigneten Material aufweisen, die im Fehlerfall eine Ausbildung einer elektrisch leitenden Verbindung zwischen der ersten Hauptelektrode 12 und der zweiten Hauptelektrode 14 ermöglichen bzw. unterstützen. Das Metall der Metallschicht soll mit dem Material des Leistungshalbleiterbauelements 18 ein Eutektikum bilden können. Weiter muss die Dicke der Metallschicht derart bemessen sein, dass im Fehlerfall das Material der Metallschicht mit dem Material des Leistungshalbleiterbauelements einen elektrisch leitenden Kanal bilden kann wie dies im genannten Stand der Technik beschrieben ist. Weiter kann im Kontaktelement 26 eine Schicht vorgesehen sein, die thermische Spannungen aufgrund von Temperaturschwankungen kompensiert, sodass das Halbleiterbauelement 18 mechanisch, aufgrund thermischer Schwankungen, möglichst unbelastet ist. Dies kann durch eine Schicht erzielt werden, welche einen ähnlichen thermischen Ausdehnungskoeffizient aufweist, wie das Leistungshalbleiterbauelement 18 selbst.

Alternativ kann das Kontaktelement 26 auch ohne Presskontakt beziehungsweise ohne eine Feder ausgebildet sein. Ein derartiges Kontaktelement ist aus WO 2012/107482 A2 bekannt.

Um das Leistungshalbleiterbauelement 18 weiter gegen mechanische Belastungen aufgrund von thermischen Schwankungen zu schützen, kann beispielsweise zwischen dem Leistungshalbleiterbauelement 18 und der ersten Hauptelektrode 12 eine weitere Schicht aus einem Material mit einem ähnlichen thermischen Ausdehnungskoeffizient wie die des Leitungshalbleiterbauelement 18 vorgesehen sein. Alternativ kann auch die erste Hauptelektrode 12 selbst aus einem derartigen Material gefertigt sein bzw. eine Schicht aus einem derartigen Material aufweisen.

Fig. 3 zeigt eine weitere Ausführungsform der Erfindung. Diese Ausführungsform ist weitgehend gleich zu der vorstehend beschriebenen Ausführungsformen ausgebildet. Im weiteren wird nur auf die Unterschiede eingegangen. Die in Fig. 3 gezeigte Ausführungsform unterscheidet sich von der ersten, in Fig. 1 und 2 gezeigten Ausführungsform dadurch, dass die ersten Kreislinie 30 jeder Ringanordnung 28 durch ein erstes Sechseck 31 und die dazugehörige zweite Kreislinie 34 durch ein zweites Sechseck 35 angenähert ist, wobei die Ecken des ersten Sechseck auf die Ecken des zweiten Sechsecks ausgerichtet sind. Weiter zeigt diese Ausführungsform auch, dass der Rahmen 44 beziehungsweise das Gehäuse des Leistungshalbleitermoduls 10 eine sechseckige Form haben kann. Ebenso kann das Durchgangsloch 46 eine sechseckige Form haben.

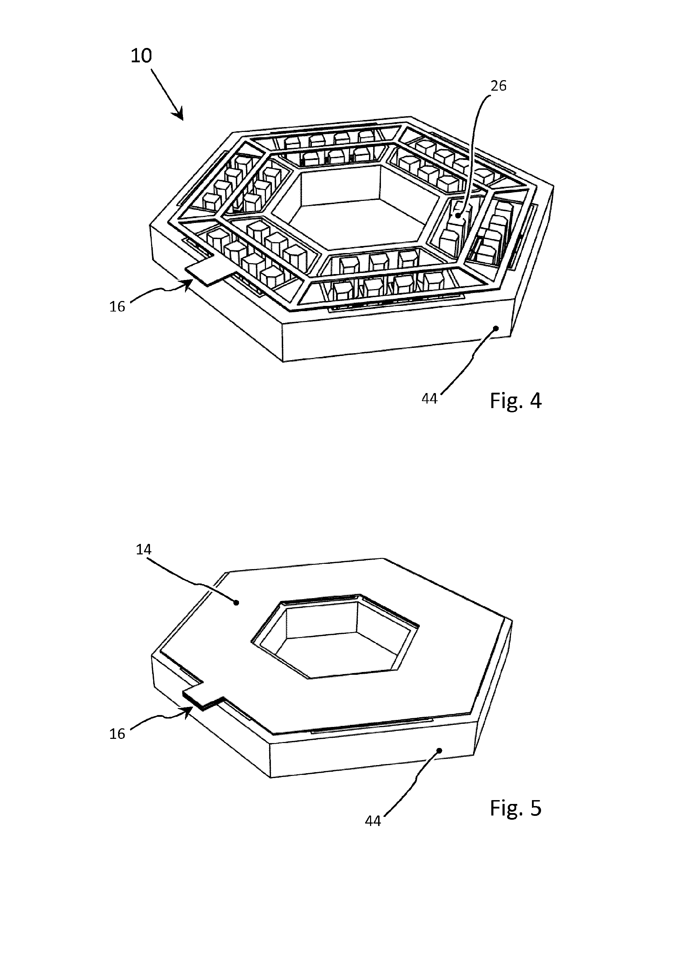

In der in Fig. 3 gezeigten Ausführungsform sind in das sechseckige Leistungshalbleitermodul 10 drei aktive Baugruppen 42 eingesetzt. Anstelle von drei aktiven Baugruppen 42 können auch sechs aktive Baugruppen in den Rahmen 44 eingesetzt werden, wie dies in Fig. 4 gezeigt ist.

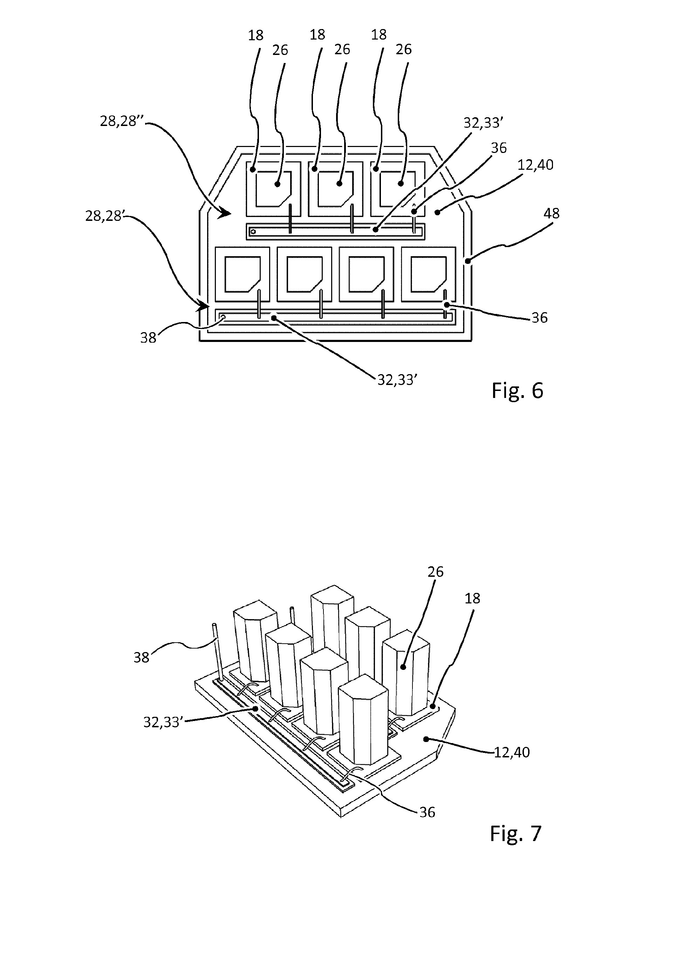

Fig. 4 zeigt eine weitere Ausführungsform des erfindungsgemässen Leistungshalbleitermoduls 10, dessen aktive Baugruppen 42 in Fig. 6 und 7 gezeigt sind. Diese Ausführungsform ist wiederum weitgehend gleich zu der vorstehend beschriebenen Ausführungsformen ausgebildet und es wird im Folgenden nur auf die Unterschiede eingegangen. Diese Ausführungsform unterscheidet sich von den anderen, bereits diskutierten Ausführungsformen durch die Anzahl der elektrisch parallel zueinander angeordneten Leistungshalbleiterbauelemente 18. Weiter zeigt diese Ausführungsform einen Baugruppenrahmen 48 , durch welchen zusammen mit der Trägerplatte 40 eine Art Wanne gebildet wird. Diese Wanne ist bevorzugt mit einem Isoliergel, wie beispielsweise Silikongel, oder einem anderen Isolierstoff ausgefüllt.

Weiter zeigt Fig. 4 eine Ausführungsform des Kontaktanschlusses 16.

In Fig. 5 ist das in Fig. 4 gezeigte Leistungshalbleitermodul 10 gezeigt, wobei die zweite Hauptelektrode auf den Rahmen 44 wie auch auf den Kontaktanschluss 16 aufgelegt ist. Durch das Auflegen treten die Kontaktelemente 26 in elektrischen Kontakt mit der zweiten Hauptelektrode 14.

In den vorstehenden Ausführungsformen wurden sechseckige Leistungshalbleitermodule beschrieben. Selbstverständlich kann das Leistungshalbleitermodul eine beliebige Anzahl von Ecken aufweisen, wobei die Anzahl der Ecken typischerweise gleich oder grösser als 3 und kleiner 10 ist, jedoch auch grösser sein könnte. Je grösser die Anzahl der Ecken ist, desto mehr nähert sich die n-eckige Ausführungsform der ersten Ausführungsform an.

Auch bei einer n-eckigen Ausführungsform liegen die Leistungshalbleiterbauelemente der entsprechenden Ringanordnung zumindest annähernd entlang einer ersten Kreislinie. Die erste Kreislinie 30 lässt sich jedoch auch durch ein erstes Vieleck 31 mit derselben Anzahl von Ecken annähern. Ebenso kann die zweite Kreislinie 34 der Ringanordnung durch ein zweites Vieleck 35 mit derselben Anzahl von Ecken angenähert werden.

In einer weiteren, in den Figuren nicht gezeigten Ausführungsform weist die elektrische Verbindung zwischen dem Kontrollanschluss 16 und jeder Kontrollelektrode 24 einen Widerstand auf.

In den bisherig beschriebenen und in den Figuren gezeigten Ausführungsformen sind die aktiven Baugruppen 42 des Leistungshalbleitermoduls 10 jeweils gleich ausgebildet. Um die beschriebene Ringstruktur möglichst einem Kreisring anzunähern kann es auch sinnvoll sein zwei oder mehr Typen von Baugruppen 42 zu verwenden, die geometrisch unterschiedlich aufgebaut sind. Beispielsweise kann die Form der Trägerplatte variiert und die Anzahl der darauf angeordneten Leistungshalbleiterbauelemente daran angepasst werden.

**Bezugszeichenliste**

| | |
|---|---|
| 10 | Leistungshalbleitermodul |
| 12 | erste Hauptelektrode |
| 14 | zweite Hauptelektrode |
| 16 | Kontrollanschluss |
| 18 | Leistungshalbleiterbauelement |
| 20 | erste Elektrode |
| 22 | zweite Elektrode |
| 24 | Kontrollelektrode |
| 26 | Kontaktelement |
| 28 | Ringanordnung |
| 28' | innere Ringanordnung |
| 28" | äussere Ringanordnung |
| 30 | erste Kreislinie |
| 31 | erstes Sechseck, erstes Vieleck |
| 32 | Kontrollleiterbahn |
| 33, 33', 33" | Kontrollleiterbahnsegment |
| 34 | zweite Kreislinie |
| 35 | zweites Sechseck, zweites Vieleck |
| 36 | elektrische Verbindung |
| 38 | weitere elektrische Verbindung |
| 40, 40', 40" | Trägerplatte |
| 42 | aktive Baugruppen |
| 44 | Rahmen |
| 46 | Durchgangsloch |
| 48 | Baugruppenrahmen |
| S | Stromführungsrichtung |

## Patentansprüche

1. Leistungshalbleitermodul (10) mit einer ersten Hauptelektrode (12), einer zweiten Hauptelektrode (14), und einem Kontrollanschluss (16) und mit steuerbaren Leistungshalbleiterbauelementen (18), welche zwischen der ersten Hauptelektrode (12) und der zweiten Hauptelektrode (14) angeordnet sind, wobei jedes steuerbare Leistungshalbleiterbauelement (18) eine erste Elektrode (20), eine zweite Elektrode (22) und eine Kontrollelektrode (24) aufweist und die erste Elektrode (20) jedes steuerbaren Leistungshalbleiterbauelementes (18) mit der ersten Hauptelektrode (12), die zweite Elektrode (22) jedes steuerbaren Leistungshalbleiterbauelementes (18) mit der zweiten Hauptelektrode (14) und die Kontrollelektrode (24) jedes steuerbaren Leistungshalbleiterbauelementes (18) mit dem Kontrollanschluss (16) elektrisch verbunden ist, **dadurch gekennzeichnet, dass** zumindest ein Teil der steuerbaren Leistungshalbleiterbauelemente (18) in einer Ringanordnung (28, 28', 28") angeordnet sind, wobei die steuerbaren Leistungshalbleiterbauelemente (18) der Ringanordnung (28, 28', 28") zumindest annähernd entlang einer ersten Kreislinie (30) der Ringanordnung (28, 28', 28") angeordnet sind und eine Kontrollleiterbahn (32) der Ringanordnung (28, 28', 28") auf der ersten Hauptelektrode (12) angeordnet ist, wobei die Kontrolleiterbahn (32) der Ringanordnung (28, 28', 28") zumindest annähernd entlang einer zweiten Kreislinie (34) der Ringanordnung (28, 28', 28") verläuft, und die zweite Kreislinie (34) der Ringanordnung (28, 28', 28") konzentrisch zur ersten Kreislinie (30) der Ringanordnung (28, 28', 28") verläuft, wobei die Kontrollelektrode (24) jedes steuerbaren Leistungshalbleiterbauelementes (18) der Ringanordnung (28, 28', 28") über eine elektrische Verbindung (36) mit der Kontrollleiterbahn (32) der Ringanordnung (28, 28', 28") verbunden ist und die Kontrolleiterbahn (32) der Ringanordnung (28, 28', 28") über eine weitere elektrische Verbindung (38) mit dem Kontrollanschluss (16) verbunden ist.

2. Leistungshalbleitermodul nach Anspruch 1, **dadurch gekennzeichnet, dass** die erste Kreislinie (30) durch ein erstes Vieleck (31) und die dazugehörige zweite Kreislinie (34) durch ein zweites Vieleck (35) mit derselben Anzahl Ecken wie das erste Vieleck (31) angenähert ist, wobei die Ecken des ersten Vieleckes (31) auf die Ecken des zweiten Vieleckes (35) ausgerichtet sind.

3. Leistungshalbleitermodul nach Anspruch 1 oder 2, **dadurch gekennzeichnet, dass** die zweite Kreislinie (34) ausserhalb der ersten Kreislinie (30) liegt.

4. Leistungshalbleitermodul nach einem der Ansprüche 1 bis 3, **dadurch gekennzeichnet, dass** das Leistungshalbleitermodul (10) aktive Baugruppen (42) aufweist, wobei jede aktive Baugruppe (42) eine Trägerplatte (40, 40', 40") aufweist, und die Trägerplatten (40, 40', 40") der aktiven Baugruppen (42, 42', 42") zusammen die erste Hauptelektrode (12) bilden,
jede Ringanordnung (28, 28', 28") durch die aktiven Baugruppen (42) in Ringsegmente aufgeteilt ist, wobei die aktiven Leistungshalbleiterbauelemente (18) des Ringsegmentes auf der Trägerplatte (40) angeordnet sind, und die Kontrolleiterbahn (32) der jeweiligen Ringanordnung (28, 28', 28") in Kontrolleiterbahnsegmente (33,33',33") der Ringanordnung (28, 28', 28") unterteilt ist, wobei die Kontrollelektrode (24) jedes Leistungshalbleiterbauelementes (18) des jeweiligen Ringsegments mit dem Kontrolleiterbahnsegment (33, 33', 33') des jeweiligen Ringsegments verbunden ist.

5. Leistungshalbleitermodul nach einem der Ansprüche 1 bis 4, **dadurch gekennzeichnet, dass** das Leistungshalbleitermodul (10) mehrere, konzentrisch zueinander angeordnete Ringanordnungen (28, 28', 28") aufweist.

6. Leistungshalbleitermodul nach Anspruch 5, **dadurch gekennzeichnet, dass** sich die Ringanordnungen nicht überlappen beziehungsweise überlappungsfrei sind.

7. Leistungshalbleitermodul nach einem der Ansprüche 1 bis 6, **dadurch gekennzeichnet, dass** alle aktiven Leistungshalbleiterbauelemente (18) in der Ringanordnung (28) beziehungsweise den Ringanordnungen (28, 28', 28") angeordnet sind.

8. Leistungshalbleitermodul nach einem der Ansprüche 1 bis 7, **dadurch gekennzeichnet, dass** die aktiven Baugruppen (42) des Leistungshalbleitermoduls (10) alle gleich ausgebildet sind.

9. Leistungshalbleitermodul nach einem der Ansprüche 1 bis 8, **dadurch gekennzeichnet, dass** zwischen der zweiten Hauptelektrode (14) des Leistungshalbleitermoduls (10) und jedem steuerbaren Leistungshalbleiterbauelement (18) ein elektrisch leitendes Kontaktelement (26) angeordnet ist, welches die zweite Hauptelektrode (14) mit der zweiten Elektrode des Leistungshalbleiterbauelements (18) verbindet, wobei durch das Kontaktelement (26) und das Leistungshalbleiterbauelement (18) eine Stromführungsrichtung (S) definiert wird, welche zumindest annähern rechtwinklig zur ersten Hauptelektrode (12) ist.

10. Leistungshalbleitermodul nach Anspruch 9, **dadurch gekennzeichnet, dass** jedes Kontaktelement (26) als Presskontakt ausgebildet ist.

11. Leistungshalbleitermodul nach Anspruch 9 oder 10, **dadurch gekennzeichnet**, die weitere elektrische Verbindung (38) zumindest im Wesentlichen parallel zur Stromführungsrichtung (S) verläuft.

12. Leistungshalbleitermodul nach einem der Ansprüche 4 bis 11, **dadurch gekennzeichnet, dass** das Leistungshalbleitermodul (1) einen Rahmen (40) aus Isoliermaterial aufweist, in welchen die aktiven Baugruppen (30) eingesetzt sind.

13. Leistungshalbleitermodul nach einem der Ansprüche 1 bis 12, **dadurch gekennzeichnet**, das das Leistungshalbleitermodul ein zentrales Durchgangsloch aufweist.
